# EUROPEAN PATENT APPLICATION

(11) **EP 0 817 271 A1**
(43) Date of publication of application: **07.01.1998**
(21) Application number: 97830301.4
(22) Date of filing: 25.06.1997
(51) Int. Cl.: H01L 27/115

(54) **Semiconductor memory device with erasable sectors**

(30) Priority: 28.06.1996 IT RM960463
(71) Applicant: TEXAS INSTRUMENTS INCORPORATED, Dallas, Texas 75243 (US); TEXAS INSTRUMENTS ITALIA S.p.A., 67051 Avezzano (AQ) (IT)
(72) Inventor: Pitts, Robert L., Dallas, Texas 75248 (US); Menichelli, Stefano, 00173 Roma (IT)
(74) Representative: Taliercio, Antonio

(57) **Abstract**

Aiming at defining n erasable sectors of a memory array, for each pair of said sectors, two separation or insulation wordlines are identified for said sectors, they are separated from the corresponding overlying parallel second metal lines (METAL 2) and are connected to ground at the edges of the array, so that said overlying parallel second metal lines (METAL 2) are free standing, then, in positions corresponding to the insulation or separation wordlines, the first metal lines (METAL 1) for interconnection of the array source are divided into n segments by which n region of said common array source are identified and periodical connections are effected between said first metal lines (METAL 1) and said second free metal lines (METAL 2) corresponding to said segments, so that it is possible to independently drive any one of said n regions of common array source through said second metal lines (METAL 2) and said first metal lines (METAL 1) associated thereto, respectively, without disturbing the other n-l common source regions.

## Description

This invention broadly relates to semiconductor memory devices and more particularly it concerns a novel architecture for a Flash EEPROM memory horizontally sectored for performing deletion or erasure operations.

As is well known, a single byte can be programmed into Flash EEPROM memories. Such memories are implemented by means of MOS transistors having, as a characterising feature, a built-in floating gate or insulated gate, which is formed by a completely insulated conductor region underlying the control gate. The term "floating" is justified by the fact that, since this region is completely or effectively insulated, it takes up a voltage potential directly dependent upon the charge that is injected therein or removed therefrom. The cells of memories of this kind are programmed by applying suitable voltages to the gate, source and drain regions of the transistors from which they are formed. In fact, the injection of charges into the floating gate or removal of charges therefrom entail an alteration of the intrinsic characteristics of the associated MOS transistor, the most relevant of which being its turn-on voltage and its threshold voltage.

In memories of this kind, it is possible to program a byte (namely, 8 bits), by conventionally writing all zeros therein. As mentioned above the memory cells are programmed by applying suitable voltages to their gate, source and drain regions. As a matter of fact, the control gate region is raised to 12 volts, the source region is held at ground potential and the drain region is raised to 6 volts. By this means, a sufficiently high current flows between the source region and the drain region and this current generates the so-called hot electrons which, under the action of the 12 volts transversal voltage and consequently under the action of the resulting transversal electric field are able to 'jump" into the floating gate where they are trapped, since such a region is effectively an insulated structure.

However, a noticeable limitation, exists in memories of this kind. In fact, if it is possible to select a single cell to be programmed, the erasure operations cannot be made with the same selectivity, as will now be explained.

As is known to those skilled in the art, a write operation in a cell is carried out by injecting electrons into the floating gate region, while an erasure operation entails the removal of electrons from the floating gate region. Since the floating gate is separated from the transistor channel by an extremely thin oxide layer (about 100 Å), under the rules of the quantum theory, when a high electric field is applied across this thin oxide layer, it is possible to obtain a slow leakage of the electrons trapped therein, due to the so-called tunnel effect. The development of this necessary electric field is achieved by application of suitable voltages, for instance, to the gate and source regions. The above mentioned limitation is that it is not possible to select a single byte for erasure, as can be made in write operations and as is possible in EEPROM memories. In Flash EEPROM memories, any erasure operations can be made, in the best conditions, only on the basis of whole regions. This is clearly a limitation because it necessarily eliminates some bytes the erasure of which is not desired.

Aiming at avoiding the necessity to erase a whole cell array or matrix, divided into individually erasable sub-matrices or sub-arrays. It can be seen that, the smaller the sub-arrays are, the more selective the erasure will be, even if it can never reach a single-byte level. Anyway, the division of the main array into sub-arrays entails a strong disadvantage in terms of exploitation of the silicon area, due to the resulting need to introduce, for each sub-array, the necessary closure or termination accessory items, the so-called dummy cells, which enable the continuity of the matrix to be preserved. A certain division has been tolerated up to now, but it has not been exploited beyond a certain limit.

It is a broad object of this invention to provide a method for performing an effective memory, rather than merely a virtual division of a memory cell array into sectors or sub-arrays adapted to be individually erased. Preferably this is effected without stressing or at least under minimum stress of any other sub-arrays the erasure of which is not desired and, without any penalty in terms of silicon area for termination of the erasable sectors.

Summarising and underlining all above said concepts, conventional Flash EEPROMs are typically subdivided into submatrices or subarrays for two main reasons: 1) to improve to the maximum possible extent the speed performances and/or 2) to subdivide the memory into erasable sectors. In particular, in an H-type Flash memory cell matrix, all cells of a row have their control gates electrically connected together, in view of the fact that they are formed by a single polysilicon strip, which is designated as a wordline. At one side of the horizontally extending wordline, the drain contacts of the cells are arranged, each of said contacts being shared between two cells, a first cell pertaining to the associated row and the second one pertaining to the adjacent row. All drain regions arranged in a column are electrically connected, by means of the above mentioned contacts, to vertically extending metal strips METAL 1, designated as bitlines. As many bitlines are included in a matrix, as cells are included in a row.

On the other side of the wordline, an N+ type diffusion region is provided and acts as a single source region shared among all cells of the associated row and the ones of an adjacent row. Such source regions which are horizontally extended and are alternately arranged with the drain regions, between wordlines, are electrically connected together by means of further vertical metal strips, METAL 1, which are electrically connected together externally to the cell array and define the above said common source. For H-cell memories, the conventional erasure operation is carried out by driving the common array source and the wordlines by suitable voltages, while the bitlines are left floating. Since all source regions of the H-cells are common to a whole subarray, any erasure operation is typically carried out on the whole subarray. Should it be desired that the size of an erasable sector be smaller.

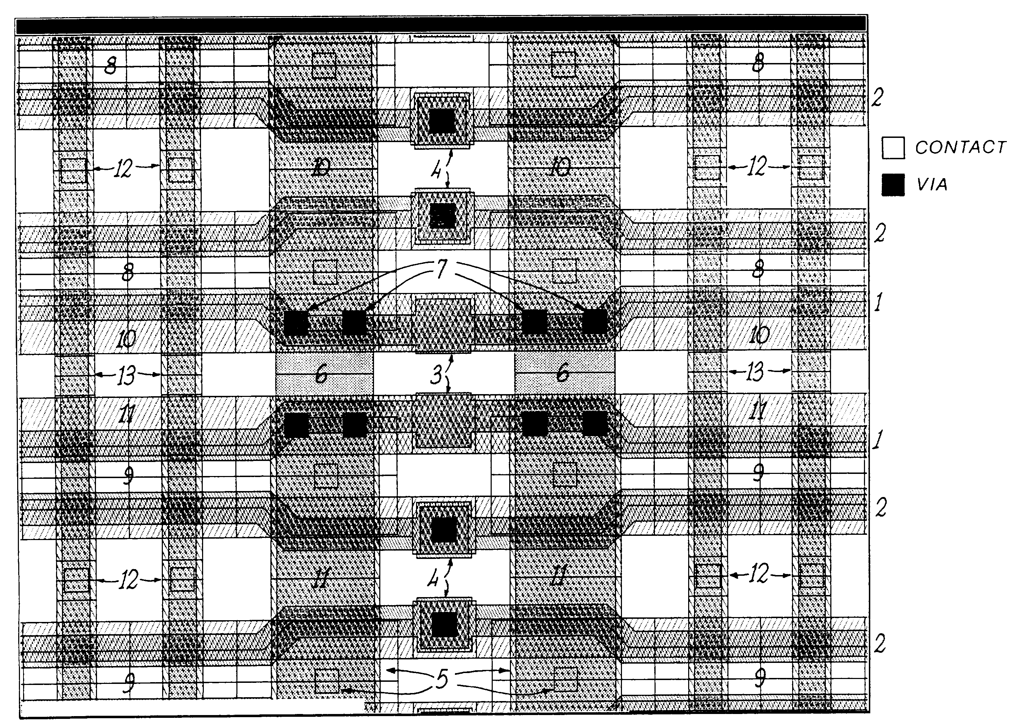

The schematic view shown in Figure 1 is designed to carry out a source insulation within a H-cell array and to enable the source regions of the individual erasable sectors to be independently driven. By this approach, it is possible to erase a subarray of the cell array without affecting these remaining. The wordlines and the source regions of the cells of the subarray to be erased will be driven by voltages having a value sufficient for erasure purposes, while the remaining wordlines and the remaining source regions are connected to ground.

This source insulation effect is achieved by insertion of two wordlines connected to ground between adjacent erasable sectors, as will now described.

All Flash memory arrays have their wordlines made of polycrystalline silicon or so-called polysilicon. Since polysilicon has a high resistance (sheet resistance), provisions are made to periodically connect (for instance at a pitch of 16 or 32 or even 64 memory cells) each wordline 2 to a parallel overlaying metal line (horizontally extending METAL 2), which enables a low resistance path to be established, as required in order to save the speed performances of the memory. The polysilicon wordlines 1 by which the source insulation effect is obtained are permanently connected to ground at the edges of the array. All connections 3 between the wordlines 1 permanently connected to ground and the horizontally extending metal lines (METAL 2) associated thereto are removed so as to enable these metal lines to be utilized to furnish a separate source voltage for each erasable sector. This facilitates the array source connections 4 for as many erasable sectors as are desired. At the same time, the underlying topology of the array is maintained, thereby increasing the array continuity to the maximum extent in adjacency to contiguous addressed cells.

Summarizing and completing the above explanations, this invention effectively suggests the insertion of two dummy wordlines 1 and eliminates the contacts 3 by which two effective wordlines are connected to their corresponding horizontally extending metal lines (METAL 2). The polysilicon of such dummy wordlines 1 is connected to ground at the edges of the array. In this manner, two free METAL 2 lines are formed.

At this stage, also considering that the common sources are connected together by means of vertically extending metal lines 5 (METAL 1), let us suppose that such vertically extending metal lines (METAL 1) are sectioned 6 between said two insulating dummy wordlines. Two segments of METAL 1 (5) are obtained in this manner and, since the common sources are vertically extended, when the METAL 1 lines are sectioned 6, two common sources (10, 11) or, more precisely, two common source regions are formed. Thereafter, those METAL 2 lines 1 that have been previously disconnected from the underlying polysilicon of the insulation dummy wordlines 1 are connected 7 to the METAL 1 line segments by which said two common source regions (10, 11) are formed.

Summarizing, the horizontally extending METAL 2 lines 1 contact all vertically extending METAL 1 line segments 2 which, in turn, define and contact respective common source regions, thereby enabling said common source regions to be driven through said two metals. This result is achieved without disrupting the array continuity, by utilizing only the two metal lines and at the expense of only said two wordlines that are made dummy. Such expense, when evaluated the global memory economy view point, is effectively to be considered as minimum, in comparison to the silicon area penalty connected with the above mentioned otherwise necessary reticulation by which the array is "completely equipped". A certain reticulation will anyway be necessary, but it will be exclusively connected with the subdivision of the array into subarrays, aimed at optimizing the speed performances and no more determined by erasability reasons.

The above described arrangement, of course, can be repeated n times.

The preferred source insulation arrangement performs quite well in all those erasure conditions wherein the erasure voltage is distributedly supplied to the wordlines and to the array sources or it is only coupled to the array sources, while all wordlines 1 are connected to ground. When the erasure voltage is distributed, the wordlines of each erasable sector are independently driven while the erasure is performed. The wordlines of the cells being erased are driven to a negative voltage, while the sources are driven to a positive voltage. The wordlines of the cells not to be affected as well as the respective sources are connected to ground.

By referring to Figure 1, the two insulation rows (in horizontal direction) and the cells by which the polysilicon wordlines are connected to the corresponding parallel metal lines, also called wordline strap cells, are shown. The contacts and the interconnections (vias) used to connect the two insulation wordlines to the overlaying parallel metal lines are not shown in Figure 1.

In the above shown implementation and considering that the concerned structure is realized in mirrored form, the metal lines can be used to supply the subarray with two different source voltages, a first voltage to erase erasable sector n at the top portion of Figure 1 and a second voltage to erase erasable sector (n + 1) at the bottom portion of Figure 1. The above mentioned source voltages enter the array through horizontal metal lines (METAL 2) that are periodically connected to the vertical metal lines (METAL 1) which couple these source voltages to each desired erasable sector. It should be noted that the drain contacts of the memory cells have been removed from the insulation cells in order to guarantee that no interference arise with the bitlines formed by metal lines METAL 1.

By specific reference to the Figure, the reference numerals have the following meanings:
1. - insulation wordlines connected to ground at the edges of the array;
2. - active wordlines connected to overlying metal lines METAL 2;
3. - removed contacts and interconnections (vias) for the insulation wordlines;
4. - effectively existing contacts and interconnections (vias) for active wordlines;
5. - vertical METAL 1 with its contacts to the underlying MOAT common source;
6. - removed METAL 1 between insulation wordlines;
7. - interconnections (vias) to connect the horizontal METAL 2 lines to the vertical METAL 1 lines;
8. - horizontal common source connected to vertical METAL 1 line for erasable sector n;
9. - horizontal common source connected to vertical METAL 1 line for erasable sector (n + 1);
10. - common source metal connections for erasable sector n;
11. - common source metal connections for erasable sector (n + 1);
12. - vertical bitlines (METAL 1) with their contacts to the underlying MOAT region of Flash cells (drain);
13. removed bitline contacts between insulation wordlines.

The main advantage of the arrangement according to this invention is achieved in exploiting the silicon area of the integrated circuit. This arrangement, in fact, exploits said area in more efficient way, particularly when the size of the erasable sector is smaller than the size as determined by speed requirements. This occurs in view of the fact that the conventional Flash EEPROM memory arrays are fully equipped into submatrices or subarrays for each erasable sector, while the insulation namely the determination of the erasable sectors is performed only by means of two not otherwise utilized memory cell rows. The costs connected with fully equipping the array for conventional memories is high because at each border between erasable sectors two subarray terminations and one subarray gap are needed. As above said, a subarray termination comprises unutilized cells (dummy cells) arranged around the active array area and all proper terminations at all utilized levels of the array, for continuity reasons. Furthermore, it typically comprises an array substrate ring.

The preferred embodiment has been hereinbefore described and some changes have been suggested, but it should be understood that those skilled in the art can make further changes, modifications and variations to the details and manufacturing particulars, without so departing from the scope of this invention.

## Claims

1. A memory comprising;
an array of memory cells each formed from a transistor, said memory cells being arranged in rows and columns such that a control region of each transistor in a respective one of said rows is connected to the control region of each other transistor in said row by a wordline (1,2), a first current guiding region of each transistor in a respective one of said columns is connected to the first current guiding region of each other transistor in said column by a bitline, a second current guiding region of each transistor being connected to the second current guiding region of each other transistor by a first conductive line (METAL 1) arranged to form a common current guiding region (10,11) and by a substantially parallel set of second conductive lines (METAL 2) substantially overlying each wordline and periodically connected thereto;
said array of memory cells being divided to form n erasable sectors, each pair of sectors being provided with an associated pair of separation wordlines (1) separated from a corresponding overlying set of second conductive lines (METAL 2) and arranged for connection to a ground potential;
said first conductive lines (METAL 1) being divided to define n portions of said common current guiding region (10,11) in regions substantially corresponding to said separation wordlines (1), each of said n portions having a connection between the first conductive line (METAL 1) and the second conductive line (METAL 2) such that application of a first potential to the control region and a second potential substantially opposite that of the first potential to any of said n portions of said common current guiding region (10,11) corresponding to the or each selected memory cell through said first conductive line and said second conductive line associated thereto causes the or each selected memory cell to be erased.

2. The memory cell as claimed in Claim 1, wherein application of a first potential to the control region and a second potential substantially opposite that of the first potential to any of said n portions of said common current guiding region (10,11) corresponding to the or each selected memory cell through said first conductive line and said second conductive line associated thereto causes the or each selected memory cell to be independently erased.

3. The memory as claimed in Claim 1 or Claim 2, wherein contacts to each first current guiding region of cells disposed between the separation wordlines are removed to eliminate any interference to the bitlines.

4. The memory as claimed in any preceding claim, memory is a Flash memory.

5. The memory as claimed in any preceding claim, wherein said array of memory cells comprises H-type cells.

6. The memory as claimed in any preceding claim, wherein said transistors are MOS transistors.

7. The memory as claimed in any preceding claim, wherein said wordlines are formed from polysilicon.

8. The memory as claimed in any preceding claim, wherein said n erasable sections are connected to a ground potential substantially at an edge of said array.

9. A method of forming a semiconductor memory having an array of memory cells each formed from a transistor, said memory cells being arranged in rows and columns such that a control region of each transistor in a respective one of said rows is connected to the control region of memory cells of each other transistor in said row by a wordline, a first current guiding region of each transistor in a respective one of said columns is connected to the first current guiding region of each other transistor is said column by a bitline, a second current guiding region of each transistor being connected to each other second current guiding region by a first conductive line arranged to form a common current guiding region and by a substantially parallel set of second conductive lines (METAL 2) substantially overlying each wordline and periodically connected thereto, which method comprising;
arranging said array of memory cells to form n erasable sectors, each pair of sectors being provided with an associated pair of separation wordlines;
separating said separation wordlines from a corresponding overlying set of second conductive lines (METAL 2), and arranging said separation wordlines for connection to a ground potential;
dividing said first conductive lines (METAL 1) to define n portions of said common current guiding region (10,11) in regions substantially corresponding to said separation wordlines (1), each of said n portions having a connection between the first conductive line (METAL 1) and the second conductive line (METAL 2);
applying a first potential to the control region and applying a second potential substantially opposite that of the first potential to any of said n portions of said common current guiding region (10,11) corresponding to the or each selected memory cell through said first conductive line and said second conductive line thereby causing the or each selected memory cell to be erased.

10. A Flash EEPROM memory comprising an array of H-type cells realized by means of MOS transistors organized by horizontal rows and vertical columns so as to have all control gates of the cells of each row connected together by means of horizontally extending wordlines consisting of polysilicon, all drains of a column connected together by means of vertically extending bitlines, all sources connected together by means of first metal lines (METAL 1), vertically extending so as to form a common array source, as well as a set of second parallel metal lines (METAL 2) horizontally extending and overlying said wordlines and periodically connected thereto,
characterized in that,
aiming at defining n erasable sectors of an array, for each pair of said sectors, two separation or insulation wordlines are identified for said sectors, they are separated from the corresponding overlying parallel second metal lines (METAL 2) and are connected to ground at the edges of the array, so that said overlying parallel second metal lines (METAL 2) are free standing, then, in positions corresponding to the insulation or separation wordlines, the first metal lines (METAL 1) for interconnection of the array source are divided into n segments by which n region of said common array source are identified and periodical connections are effected between said first metal lines (METAL 1) and said second free metal lines (METAL 2) corresponding to said segments, so that it is possible to independently drive any one of said n regions of common array source through said second metal lines (METAL 2) and said first metal lines (METAL 1) associated thereto, respectively, without disturbing the other (n-1) common source regions.
